Europäisches Patentamt

European Patent Office

Office européen des brevets

(19)

(11) Publication number: **0 254 136 B1**

(12) **EUROPEAN PATENT SPECIFICATION**

(45) Date of publication of patent specification: 13.03.91 (51) Int. Cl.5: **H01J 29/45,** H01L 31/08, H01L 31/00

(21) Application number: 87109860.4

(22) Date of filing: 08.07.87

(54) Image pick-up tube target.

(30) Priority: 11.07.86 JP 161805/86

(43) Date of publication of application:
27.01.88 Bulletin 88/04

(45) Publication of the grant of the patent:
13.03.91 Bulletin 91/11

(84) Designated Contracting States:
DE FR

(56) References cited:
US-A- 4 330 733

Patent Abstract of Japan, unexamined ap-
plications, E section, vol 6, no 160, August
21, 1982 THE PATENT OFFICE JAPANESE
GOVERNMNENT page 93E126

Patent Abstract of Japan, unexamined ap-
plications, E section, vol 6, no 60, April 17,
1982 THE PATENT OFFICE JAPANESE GOV-
ERNMENT page 30E102

(73) Proprietor: HITACHI, LTD.
6, Kanda Surugadai 4-chome
Chiyoda-ku, Tokyo 101(JP)

(72) Inventor: Unnai, Takaaki
3550, Hayano
Mobara-shi Chiba-ken(JP)
Inventor: Nonaka, Yasuhiko
38-2, Modori-cho
Mibara-shi Chiba-ken(JP)
Inventor: Inoue, Eisuke
3550, Hayano
Mobara-shi Chiba-ken(JP)

(74) Representative: Patentanwälte Beetz sen. -
Beetz jun. Timpe - Siegfried - Schmitt-
Fumian
Steinsdorfstrasse 10
W-8000 München 22(DE)

## Description

This invention relates to an image pick-up tube target as described in the first part of claim 1 and, more particularly to an improved structure of a rectifying contact type image pick-up tube target comprising a P-type photoconductive layer containing Se as a major constituent, and also As and Te or other materials and a beam landing layer, featuring little variation in signal current-target voltage characteristic during a long term operation.

A photoconductive image pick-up tube target utilizing a rectifying contact between a P-type photoconductive layer comprising amorphous Se, Te, As and other materials and N-type material is disclosed in US-A-3,890,525, US-A-3,922,579, US-A-3,984,722, US-A-4,040,985, and US-A-4,330,733.

A photoconductive image pick-up tube target having all the features described in the first part of claim one is known from said US-A-4,040,985.

The advantages of an image pick-up tube target of this type are high speed response, little image flare, high resolution and ease of manufacture.

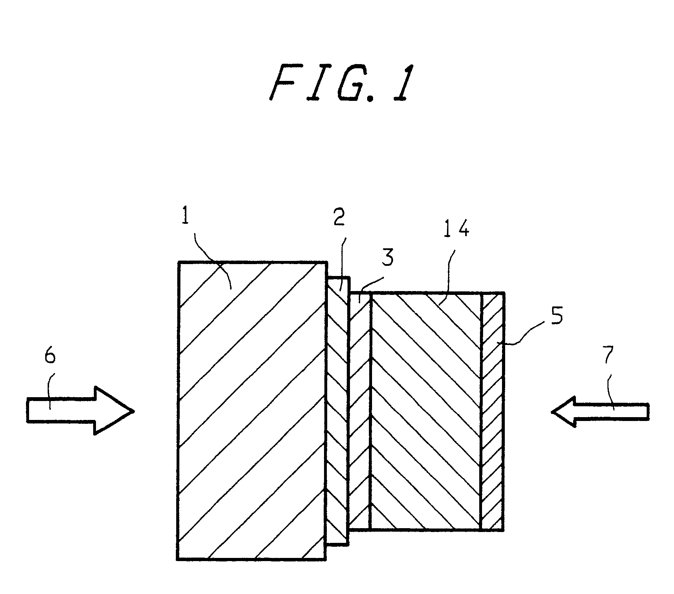

FIG. 1 shows a section of a main part of an image pick-up tube target. A transparent conductive film 2 containing $SnO_2$ or $In_2O_3$ as a major constituent is formed on the rear surface of a transparent glass substrate 1. A very thin N-type transparent conductive film 3 of zinc selenide, germanium oxide, cerium oxide, lithium fluoride or the like is formed on the rear surface of the transparent conductive film 2. A P-type photoconductive film 14 of several $\mu$m (microns) in thickness containing amorphous Se as a major constituent is deposited on the N-type transparent conductive film 3 to form a rectifying contact with the N-type conductive film 3. A beam landing layer 5 of $Sb_2S_3$ or the like is deposited to be about 100$\mu$m (1000Å) thick on the P-type photoconductive layer 14.

Incident light 6 from a scene enters the transparent glass substrate 1 and a scanning beam 7 lands on the $SB_2S_3$ layer 5 to convert the light image into electrical signals.

Since Se is not sensitive to long wavelength radiation, it has been proposed to add Te into a portion of several hundreds Å (1Å = 0.1 $\mu$m) in thickness near the rectifying contact of the Se-containing layer 14 with a peak concentration of 20 to 50 % by weight in order to improve the sensitivity to long wavelength radiation. This method is disclosed in US-A-3,890,525 and US-A-4,040,985.

The amorphous photoconductive layer 14 with Se as a main component is easily crystallized by heat, resulting in appearance of white dots in a reproduced picture. As is doped throughout the P-type photoconductive layer 4 in order to increase the viscosity and to decrease the speed of crystallization. In this case, the P-type photoconductive layer 14 is formed by evaporation of a compound containing a predetermined amount of Se an As, or by alternate evaporation of thin layers less than 100Å of Se and $As_2Se_3$ as disclosed in US-A-3,800,194.

An image pick-up tube target of the aforementioned conventional type leaves much to be desired in terms of sensitivity- and sensitivity saturation-target voltage characteristics and suppression of dark current. A poor sensitivity saturation characteristic requires a higher target voltage to be applied, and increase in dark current results in degradation of a reproduced picture.

US-A-4,219,831 discloses a method to improve sensitivity- and sensitivity saturation-target voltage characteristics and to suppress dak current by limiting a whole amount of As doped into the P-type photoconductive layer in a range between 2.5 and 6 % by weight.

Japanese Patent Publication (Kokoku) No. SHO.57-44030 discloses a method to prevent cracking of a beam landing layer made of $Sb_2S_3$ due to rapid temperature changes or operation under high temperature conditions by doping As of 10 to 20 % by weight in the region of the P-type photoconductive layer of about the same thickness as that of the beam landing layer of $Sb_2S_3$ and adjacent to the beam landing layer.

However, the aforementioned conventional image pick-up tube targets had signal current-target voltage characteristics varied during a long term continuous operation due to changes in internal electric field within the target, resulting in deterioration of picture quality.

It has been one of demands by TV camera users to improve the signal current-target voltage characteristic for the purpose of reproduction of higher quality pictures.

It is, therefore, an object of the present invention to provide an image pick-up tube target capable of eliminating variations in signal current-target voltage characteristic during a long term continuous operation.

The above mentioned object can be accomplished by the present invention which provides an image pick-up tube target comprising an N-type conductive film formed on a transparent substrate, and a P-type photoconductive film in rectifying contact with the N-type conductive film and comprising a first layer containing As and Se, a second layer containing As, Te and Se, a third layer containing As and Se, and a fourth layer containing As and Se, in the order named, and a beam landing layer, characterized in that a fifth layer containing As and Se is interposed between said fourth layer and said beam landing layer, the concentration of As of said fifth layer being in the range of 8 to 20%

by weight and being higher than that of As of said fourth layer, and the thickness of said fifth layer being in the range of 5 to 50% of the total thickness of said P-type photoconductive film, that the average concentration of As in said first layer is below 8% by weight, and that the concentration of As in said third layer decreases continuously along the direction of thickness toward said fourth layer.

FIG. 1 shows a sectional view of a target used in an image pick-up tube target;

FIG. 2 illustrates a schematic view, in section and not to scale, along with a concentration distribution diagram, showing one embodiment of the image pick-up tube target according to the invention;

FIG. 3 shows dark current vs. thickness of the fifth layer characteristics in an image pick-up tube incorporating an image pick-up tube target of FIG. 2.

The function of As doped in the amorphous Se photoconductive layer is as explained before, and by increasing an amount of doped As cracking of a beam landing layer made of $Sb_2S_3$ is prevented because viscosity of an amorphous Se photoconductive layer is increased and the speed of its crystallization is decreased and the coefficient of thermal expansion of the amorphous layer is lowered.

However, the present inventors have found that increasing the concentration of As throughout the entire amorphous Se layer increases dark current in an image pick-up tube target. Doped As functions as traps for carriers generated by incident light, and captured electrons modify internal electric field in the amorphous Se layer, and the electric field especially in the region containing Te as a sensitizer is strong enough for positive holes to be easily injected from the N-type conductive layer, resulting in increase in dark current.

It was found that dark current is within an acceptable value if the average amount of As doped in the region of a P-type photoconductive layer ranging from the rear surface of an N-type conductive film to 300 $\mu$m (3000Å) is below 8 %, preferably 2.5 to 6 % by weight.

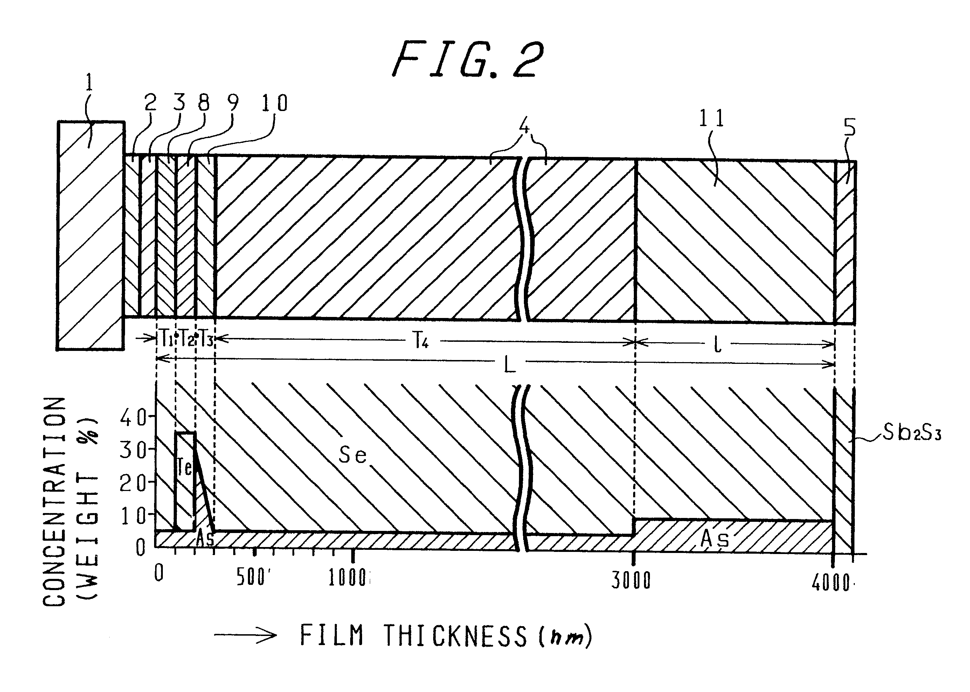

FIG. 2 illustrates a sectional view, along with a concentration distribution diagram, showing one embodiment of the image pick-up tube target according to the invention. The same reference numerals as in FIG. 1 denote the same parts as in FIG. 1, and a detailed description thereof will be omitted.

A transparent electrode 2 mainly composed of, for instance, $SnO_2$ is formed on a glass substrate 1 which is made of a transparent material. A very thin transparent N-type conductive film 3 composed of, for example, $CeO_2$ is formed on the upper surface of the transparent electrode 2. A first layer 8 of a P-type photoconductive film consisting of a P-type amorphous semiconductor of a Se-As system containing 5 ± 1 % by weight of As and the remainder of Se is formed to a thickness of $T_1$ = 100 ± 10 $\mu$m (1,000 ± 100Å) on the N-type transparent film 3, and a second layer 9 of the P-type photoconductive film of Se-As-Te system containing 5 ± 1 % by weight of As, 30 ± 10 % by weight of Te and the remainder of Se, is formed to a thickness $T_2$ = 100 ± 10 $\mu$m (1,000 ± 100 Å) over the upper surface of the first P-type photoconductive layer 8. A third layer 10 of the P-type photoconductive film of a Se-As system P-type amorphous semiconductor containing Se and As is formed to thickness of $T_3$ = 1,000 ± 100 Å on the second layer 9 of the P-type photoconductive film, with a concentration distribution in which a concentration of 70 ± 1 % by weight of Se and peak concentration of 30 ± 10 % by weight of As lying adjacent to the rear of the layer 9 change gradually to 95 ± 1 % by weight of Se and 5 ± 1 % by weight of As, respectively. A fourth layer 4 is formed on the third layer, containing 95 ± 1 % by weight of Se and 5 ± 1 % by weight of As to a thickness $T_4$ = 2700 $\mu$m (27,000 Å.). A beam landing layer 5 of $Sb_2S_3$ is vapor deposited to a thickness of about 100 $\mu$m (1,000 Å) on the layer 11 to be described next. A fifth layer 11 of the P-type photoconductive film of Se-As system containing As of a higher concentration than in the fourth layer 4, is interposed between the fourth layer 4 and the beam landing layer 5 with a thickness of $l$ (Å).

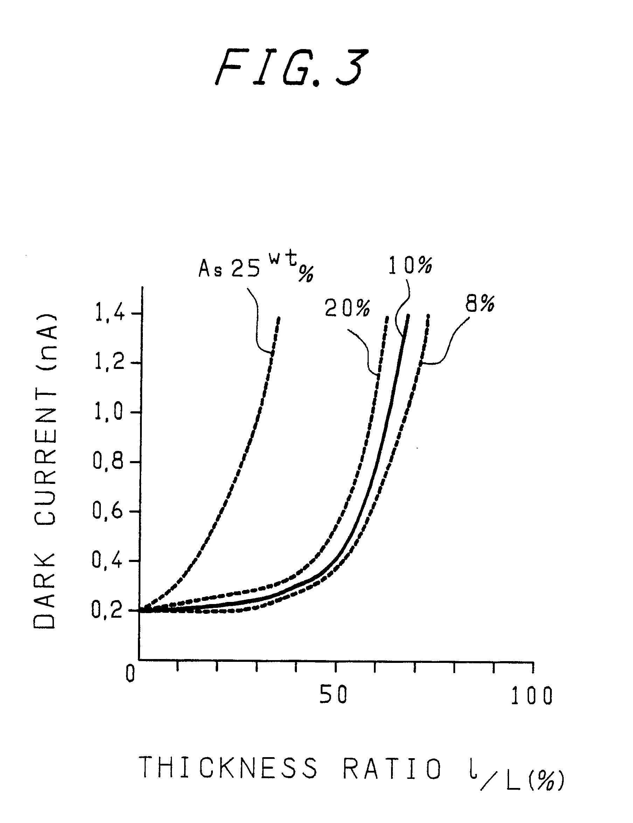

FIG. 3 shows dark current vs. ratio of thickness of a fifth layer 11, $l$ to the the total thickness of a P-type photoconductive film, L, for different concentrations of As doped in the fifth layer. It was found that dark current can be suppressed to an allowable level if the concentration of doped As is below 20 % by weight and the thickness ratio $l/L$ is less than 0.5, and that life tests showed little or no variations in signal current-target voltage characteristic occurred after a long term continuous operation of 1000 hours, thermal stability of an image pick-up tube target being ensured if concentration of As doped in the fifth layer is in the range of 8 to 20 % by weight and thickness ratio $l/L$ is in the range of 0.05 to 0.5, preferably 0.10 to 0.5. High concentration of As in the fifth layer functions as traps for electrons photogenerated during a long term continuous operation and can extract positive holes generated in the Te-containing layer, that is, the second layer of a P-type photoconductive film towards the beam landing layer of $Sb_2S_3$, thereby improves transport of positive holes through the amorphous Se layers and signal saturation characteristic.

Embodiment

An image pick-up tube target was fabricated as specified below,
in FIG. 2, T₁ = 100 μm (1000 Å), T₂ = 100 μm (1000 Å), T₃ = 100 μm (1000 Å), T₄ = 2700 μm (27,000 Å), ℓ = 1000 μm (10,000 Å).
concentration of Te in the second layer of 9 of a P-type photoconductive film is 30 % by weight,
concentration of As in the first, second, and fourth layers 8, 9, 4 is 5 % by weight,
peak concentration of As in the third layer 10 is 30 % by weight,
concentration of As in the fifth layer 11 is 10 % by weight,
thickness of Sb₂S₃ = 100 μm (1000 Å).
The image pick-up tube target produced 0.3nA of dark current, and showed little variation in signal current-target voltage characteristic after 1000 hours of operation, and no cracking of the beam landing layer made of Sb₂S₃ occurred under high temperature operating conditions.

As has been described in the foregoing, with the image pick-up tube target according to the invention it is possible to prevent variation in photocurrent-voltage characteristic after a long term continuous operation and cracking of a beam landing layer, thus permitting a picked-up image of high quality to be obtained.

## Claims

1. An image pick-up tube target comprising an N-type conductive film (3) formed on a transparent substrate (1), and a P-type photoconductive film in rectifying contact with said N-type conductive film (3) and comprising a first layer (8) containing As and Se, a second layer (9) containing As, Te and Se, a third layer (10) containing As and Se, and a fourth layer (4) containing As and Se, in the order named, and a beam landing layer (5),
   **characterized** in that
   a fifth layer (11) containing As and Se is interposed between said fourth layer (4) and said beam landing layer (5), the concentration of As of said fifth layer (11) being in the range of 8 to 20 % by weight and being higher than that of As of said fourth layer (4), and the thickness of said fifth layer (11) being in the range of 5 to 50 % of the total thickness of said P-type photoconductive film, that the average concentration of As in said first layer (8) is below 8 % by weight, and that the concentration of As in said third layer (10) decreases continuously along the direction of thickness toward said fourth layer (4).

2. An image pick-up tube target according to claim 1, wherein the concentration of As in said first, second and fourth layers (8, 9, 4) is in the range of 2.5 to 6% by weight.

3. An image pick-up tube target according to claim 2, wherein said beam landing layer (5) is made of Sb₂S₃.

## Revendications

1. Cible pour tube de prise de vues comprenant une pellicule conductrice (3) de type N formée sur un substrat transparent(1),et une pellicule photoconductrice de type p établissant un contact redresseur avec ladite pellicule conductrice (3) de type N et comprenant une première couche (8) contenant du As et du Se, une seconde couche (9) contenant du As, du Te et du Se, une troisième couche (10) contenant du As et du Se, une quatrième couche (4) contenant du As et du Se, dans l'ordre cité, et une couche (5) d'impact du faisceau,
   caractérisée en ce
   qu'une cinquième couche (11) contenant du As et du Se est intercalée entre ladite quatrième couche (4) et ladite couche (5) d'impact du faisceau, la concentration de As dans ladite cinquième couche (11) étant située dans la gamme de 8 à 20 % en poids et étant supérieure à celle du As dans ladite quatrième couche (4), et l'épaisseur de ladite cinquième couche (11) étant située dans la gamme de 5 à 20 % de l'épaisseur totale de ladite pellicule photoconductrice de type P, que la concentration moyenne de As dans ladite première couche (8) est inférieure à 8 % en poids et que la concentration de As dans ladite troisième couche (10) diminue continûment dans la direction de l'épaisseur en direction de ladite quatrième couche (4).

2. Cible pour tube de prise de vues selon la revendication 1, dans lequel la concentration de As dans lesdites première, seconde et quatrième couches (8,9,4) se situent dans la gamme de 2,5 à 6 % en poids.

3. Cible pour tube de prise de vues selon la revendication 2, dans laquelle ladite couche (5) d'impact du faisceau est formée de Sb₂S₃.

## Ansprüche

1. Target für Bildaufnahmeröhre mit einer leitenden N-Typ-Schicht (3), die auf einem transparenten Substrat (1) gebildet ist, und einer lichtleitenden P-Typ-Schicht in gleichrichtendem Kontakt mit der leitenden N-Typ-Schicht (3), die eine erste, As und Se enthaltende Schicht (8), eine zweite, As, Te und Se enthaltende Schicht (9), eine dritte, As und Se enthaltende Schicht (10) und eine vierte, As und Se enthaltende Schicht (4) in der genannten Reihenfolge aufweist, und einer Strahlauftreffschicht (5), dadurch **gekennzeichnet,**
 daß eine fünfte, As und Se enthaltende Schicht (11) zwischen der vierten Schicht (4) und der Strahlauftreffschicht (5) eingefügt ist, wobei die As-Konzentration der fünften Schicht (11) im Bereich von 8 bis 20 Gew.% und höher als die des As der vierten Schicht (4) ist und die Dicke der fünften Schicht (11) im Bereich von 5 bis 50 % der Gesamtdicke der lichtleitenden P-Typ-Schicht ist, daß die Durchschnittskonzentration des As in der ersten Schicht (8) unter 8 Gew.% ist und daß die As-Konzentration in der dritten Schicht (10) längs der Dickenrichtung zur vierten Schicht (4) hin kontinuierlich abnimmt.

2. Target für Bildaufnahmeröhre nach Anspruch 1, wobei die As-Konzentration in der ersten, zweiten und vierten Schicht (8, 9, 4) im Bereich von 2,5 bis 6 Gew.% ist.

3. Target für Bildaufnahmeröhre nach Anspruch 2, wobei die Strahlauftreffschicht (5) aus $Sb_2S_3$ besteht.

# FIG. 1

*FIG. 2*

CONCENTRATION (WEIGHT %)

FILM THICKNESS (nm)

EP 0 254 136 B1

# FIG. 3